# EUROPEAN PATENT SPECIFICATION

(11) **EP 0 682 410 B1**
(45) Date of publication and mention of the grant of the patent: **12.12.2001**
(21) Application number: 95401094.8
(22) Date of filing: 11.05.1995
(51) Int. Cl.: H03H 9/64

(54) **Elastic surface wave apparatus**
Elastische Oberflächenwellengerät
Appareil à ondes élastiques de surface

(30) Priority: 11.05.1994 JP 9752594
(43) Date of publication of application: 15.11.1995
(73) Proprietor: MURATA MANUFACTURING CO., LTD., Nagaokakyo-shi Kyoto-fu 226 (JP)
(72) Inventor: Ikada, Katsuhiro, c/o Murata Manufac. Co., Ltd., Nagaokakyo-shi, Kyoto-fu (JP); Ieki, Hideharu, c/o Murata Manufac. Co., Ltd., Nagaokakyo-shi, Kyoto-fu (JP)
(74) Representative: Joly, Jean-Jacques

(56) References cited:
- EP-A- 0 569 977
- PATENT ABSTRACTS OF JAPAN vol. 18 no. 240 (E-1545) ,9 May 1994 & JP-A-06 029779 (FUJITSU) 4 February 1994,

## Description

### BACKGROUND OF THE INVENTION

### FIELD OF THE INVENTION:

The present invention relates to an elastic surface wave apparatus which aims to decrease VSWR (Voltage Standing Wave Ratio) in the pass band of a three-electrode type in-line coupled dual mode SAW (Surface Acoustic Wave) resonator filter (hereinafter referred to as an SAW resonator filter) and to increase the amount of attenuation in the rejection band.

### DESCRIPTION OF THE RELATED ART:

In a conventional SAW resonator filter, two steps of the SAW filters are connected in a cascaded manner to increase the amount of the attenuation thereof in the rejection band.

However, in the conventional two-step cascaded SAW resonator filter, loss in the pass band thereof is increased, preventing achievement of a lower loss. In contrast to this, when the SAW resonator filter is formed only of one step to achieve a low loss, a large attenuation in the rejection band cannot be achieved, and the VSWR in the pass band is increased to 2.0 or more.

EP-A-0 600 705 and EP-A-0 569 977 disclose such conventional SAW resonator filters.

### SUMMARY OF THE INVENTION

Accordingly, it is an object of the present invention to provide an elastic surface wave apparatus which aims to decrease VSWR in the pass band and to increase the amount of attenuation in the rejection band.

The present invention provides an elastic surface wave apparatus in which a series arm resonator is connected in series to a three-electrode type in-line coupled dual mode SAW resonator filter so that the resonance frequency of the series arm resonator is in the pass band of the SAW resonator filter.

The present invention further provides an elastic surface wave apparatus in which a parallel arm resonator is connected in parallel to a three-electrode type in-line coupled dual mode SAW resonator filter so that the anti-resonance frequency of the parallel arm resonator is in the pass band of the SAW resonator filter.

The present invention still further provides an elastic surface wave apparatus in which a series arm resonator is connected in series to an outer IDT (Interdigital Transducer) of a three-electrode type in-line coupled dual mode SAW resonator filter so that the resonance frequency of the series arm resonator is in the pass band of the SAW resonator filter, and a parallel arm resonator is connected in parallel to a central IDT of a three-electrode type in-line coupled dual mode SAW resonator filter so that the anti-resonance frequency of the parallel arm resonator is in the pass band of the SAW resonator filter.

In certain embodiments of the present invention a series arm resonator is connected in series to a three-electrode type in-line coupled dual mode SAW resonator filter so that the resonance frequency of the series arm resonator is in the pass band of the SAW resonator filter. By this means reactances are cancelled in the pass band and the VSWR in the pass band is decreased, and also the amount of attenuation is increased at higher frequencies outside the pass band.

Also, in various embodiments of the present invention a parallel arm resonator is connected in parallel to a three-electrode type in-line coupled dual mode SAW resonator filter so that the anti-resonance frequency of the parallel arm resonator is in the pass band of the SAW resonator filter. By this means reactances are cancelled in the pass band and the VSWR in the pass band is decreased, and also the amount of attenuation is increased at lower frequencies outside the pass band.

In preferred embodiments of the present invention both a series arm resonator and a parallel arm resonator are connected, as described above, to a three-electrode type in-line coupled dual mode SAW resonator filter. By this means the VSWR in the pass band is decreased and also the amount of attenuation is increased at frequencies above and below the pass band.

The above and further objects, aspects and novel features of the invention will more fully appear from the following detailed description when read in connection with the accompanying drawings. It is to be expressly understood, however, that the drawings are for the purpose of illustration only and are not intended to limit the invention.

### BRIEF DESCRIPTION OF THE DRAWINGS

Fig. 1 is a connection diagram of an SAW resonator of an elastic surface wave apparatus in accordance with one presently-preferred embodiment of the present invention;
Fig. 2A is a characteristic diagram of the SAW resonator filter shown in Fig. 1, illustrating a frequency amplitude characteristic diagram of the SAW resonator filter inside and outside the pass band;
Figs. 2B and 2C are characteristic diagrams of the SAW resonator filter shown in Fig. 1, illustrating impedance Smith charts of the SAW resonator filter;
Fig. 3A is a characteristic diagram of the series arm resonator shown in Fig. 1, illustrating a frequency attenuation characteristic diagram of the series arm resonator;
Fig. 3B is a characteristic diagram of the series arm resonator shown in Fig. 1, illustrating an impedance Smith chart of the series arm resonator;
Fig. 4A is a characteristic diagram of the parallel arm resonator shown in Fig. 1, illustrating a frequency attenuation characteristic diagram of the parallel arm resonator,
Fig. 4B is a characteristic diagram of the parallel arm resonator shown in Fig. 1, illustrating an admittance Smith chart of the parallel arm resonator,
Fig. 5A is an overall characteristic diagram of the elastic surface wave apparatus shown in Fig. 1, illustrating a frequency amplitude characteristic diagram of the elastic surface wave apparatus inside and outside the pass band;
Figs. 5B and 5C are characteristic diagrams of the overall elastic surface wave apparatus shown in Fig. 1, illustrating the impedance Smith charts of the elastic surface wave apparatus; and
Fig. 6 is a simplified Smith chart of VSWR reduction in the pass band in the presently-preferred embodiment of the present invention.

### DESCRIPTION OF THE PREFERRED EMBODIMENT

A presently-preferred embodiment of the present invention will be described below with reference to the accompanying drawings.

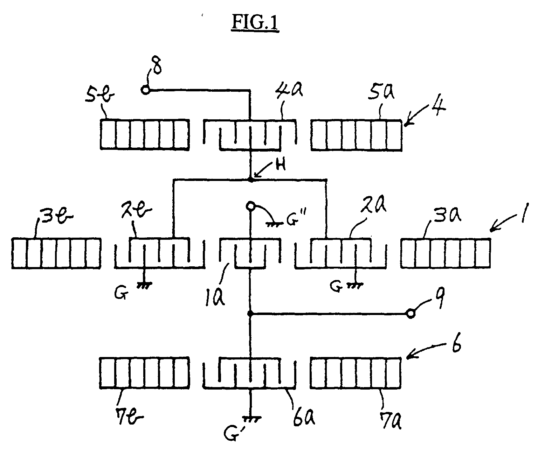

Fig. 1 shows the connection of a one-port SAW resonator (series or parallel arm resonator) of an elastic surface wave apparatus in accordance with the presently-preferred embodiment of the present invention. Referring to Fig. 1, reference numeral 1 denotes an SAW resonator filter disposed on a 36° Y-X LiTaO3 substrate, and 1a is a central IDT of the SAW resonator filter 1, an electrode on one side of the central IDT 1a being grounded. Reference numerals 2a and 2b denote outer IDTs disposed on both sides of the central IDT 1a, respectively. In the outer IDTs 2a and 2b, an electrode on one side constituting those IDTs is grounded and the electrodes on the other sides are not grounded. Reference numerals 3a and 3b denote reflectors which are disposed on both sides of the outer IDTs 2a and 2b, respectively.

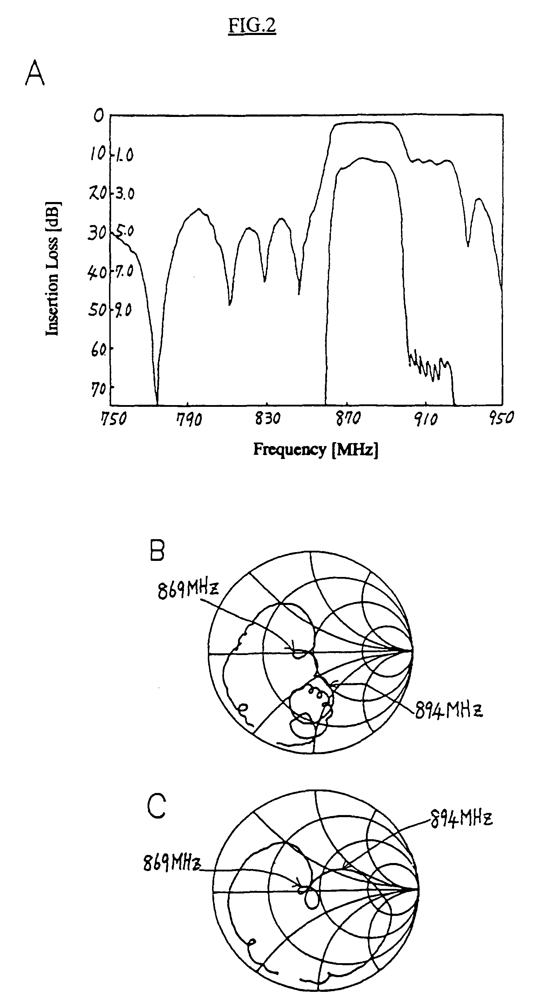

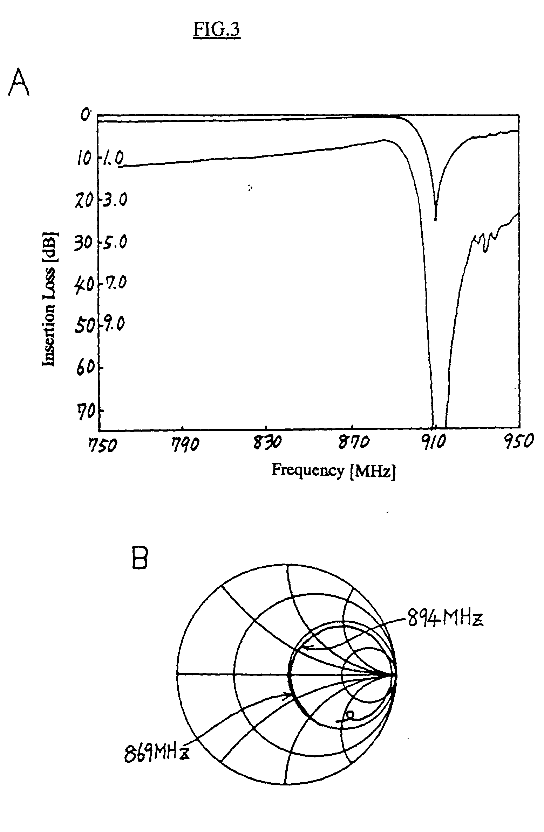

The frequency amplitude characteristic of the SAW resonator filter 1 inside and outside the pass band is shown in Fig. 2A. In Fig.2A (and in Figs.3A, 4A and 5A described below) the characteristic is graphed at two scales, a coarse scale (upper line) corresponding to units 0-70 marked on the vertical axis and a fine scale (lower line) corresponding to units 0-9.0 marked on the vertical axis. The impedance Smith charts are shown in Fig. 2B (the section between the outer IDT and the ground is formed into a terminal: i.e. terminals at points H and G of Fig.1) and Fig. 2C (the section between the central IDT and the ground is formed into a terminal: i.e. terminals at points 9 and G" of Fig.1). The pass band of the SAW resonator filter 1 is from 869 to 894 MHz.

Further, in Fig. 1, reference numeral 4 denotes a series arm resonator disposed on the 36° Y-X LiTaO₃ substrate, and 4a is an IDT of the series arm resonator 4. Reference numerals 5a and 5b denote reflectors which are disposed on both sides of the IDT 4a. An electrode on one side of the IDT 4a is connected to the outer IDTs 2a and 2b of the SAW resonator filter 1, and the other electrode is guided out and connected to an input terminal 8. The series arm resonator 4 is connected in series to the SAW resonator filter 1 so that the resonance frequency of the series arm resonator 4 is in a pass band of the SAW resonator filter 1 and the anti-resonance frequency thereof is at higher frequencies near the outside of the pass band of the SAW resonator filter 1. The frequency amplitude characteristic of the series arm resonator 4 is shown in Fig. 3A, and the impedance Smith chart is shown in Fig. 3B (between the input and output terminals).

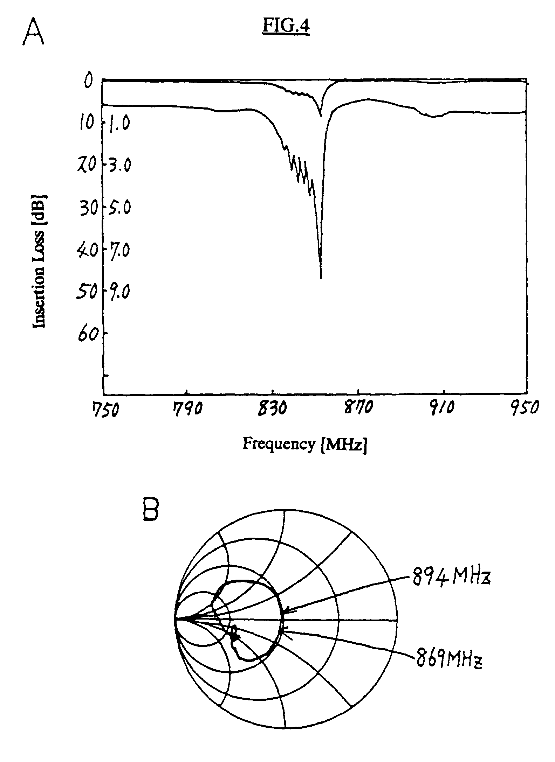

Further, in Fig. 1, reference numeral 6 denotes a parallel arm resonator disposed on a 36° Y-X LiTaO₃ substrate, and 6a is a central IDT of the parallel arm resonator 6; and reference numerals 7a and 7b denote reflectors disposed on both sides of the IDT 6a. An electrode on one side of the central IDT 6a is grounded, and the other electrodes are connected to the central IDT 1a of the SAW resonator filter 1 and an output terminal 9. The parallel arm resonator 6 is connected in parallel to the SAW resonator filter 1 so that the anti-resonance frequency of the parallel arm resonator 6 is in the pass band of the SAW resonator filter 1 and the resonance frequency thereof is at lower frequencies near the outside of the pass band of the SAW resonator filter 1. The frequency attenuation characteristic of the parallel arm resonator 6 is shown in Fig. 4A, and the admittance Smith chart is shown in Fig. 4B (between the input and output terminals).

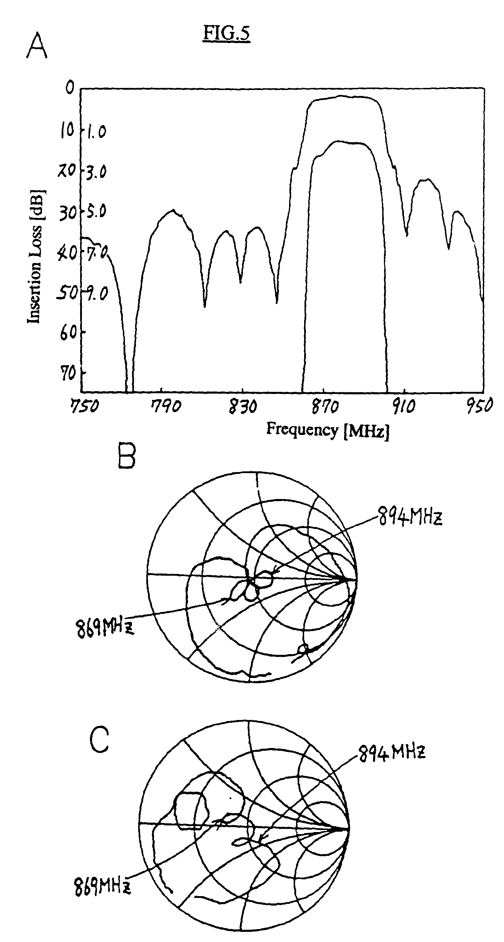

As described above, in this embodiment shown in Fig. 1, the series arm resonator 4 and the parallel arm resonator 6 are connected in series and in parallel to the SAW resonator filter 1, respectively. The frequency amplitude characteristic inside and outside the overall pass band of the assembly of the series arm resonator 4, the SAW resonator filter 1, and the parallel arm resonator 6 is shown in Fig. 5A. The impedance Smith chart is shown in Fig. 5B (the section between the input terminal 8 and the ground is formed into a terminal: i.e. terminals at points 8 and G of Fig.1) and 5C (the section between the output terminal 9 and the ground is formed into a terminal: i.e. terminals at points 9, G' and G" of Fig.1).

Fig. 2A shows the frequency amplitude characteristic inside and outside the pass band of only the SAW resonator filter 1 before the series arm resonator 4 and the parallel arm resonator 6 are connected in series and in parallel, respectively. Comparisons of Fig. 2A with Fig. 5A shows that in Fig. 5A the amount of attenuation is larger at lower and higher frequencies near the pass band.

Comparisons between Figs. 5B and 5C with Figs. 2B and 2C shows that VSWR in the pass band (869 to 894 MHz) is improved in Figs. 5B and 5C. This is due to the following reasons.

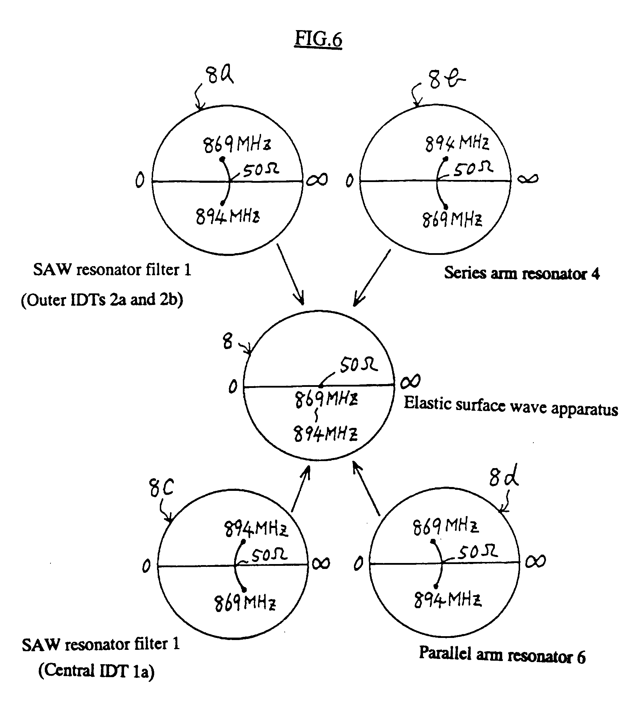

In Fig. 6, a chart 8a denotes an impedance trace in the pass band (869 to 894 MHz) of the outer IDTs 2a and 2b of the SAW resonator filter 1 in Fig. 1. A chart 8b denotes an impedance trace in the pass band of the series arm resonator 4. A chart 8c denotes an impedance trace in the pass band of the central IDT 1a of the SAW resonator filter 1. A chart 8d denotes an impedance trace in the pass band of the parallel arm resonator 6.

Connection of the series arm resonator 4 to the SAW resonator filter 1 means that the chart 8a is superimposed with the chart 8b in the frequency sequence on the impedance chart. This superimposed chart becomes chart 8, and reactances cancel each other. For example, in the 50Ω family, the reactance becomes 50Ω or thereabouts at each frequency in the pass band.

The same thing applies to a case where the parallel arm resonator 6 is connected to the SAW resonator filter 1 and the chart 8d is superimposed with the chart 8c as well.

Since in the present invention a series arm resonator is connected in series to an SAW resonator filter so that the resonance frequency of the series arm resonator is in the pass band of the SAW resonator filter, reactances cancel each other in the pass band and VSWR in the pass band is decreased, and also the amount of attenuation is increased at higher frequencies outside the pass band.

Also, since in the present invention a parallel arm resonator is connected in parallel to an SAW resonator filter so that the anti-resonance frequency of the parallel arm resonator is in a pass band of the SAW resonator filter, reactances cancel each other in the pass band and VSWR in the pass band is decreased, and also the amount of attenuation is increased at lower frequencies outside the pass band.

While the present invention has been described with respect to what is presently considered to be the preferred embodiment, it is to be understood that the invention is not limited to the disclosed embodiments. On the contrary, the invention is intended to cover various modifications and equivalent arrangements included within the scope of the appended claims. The scope of the following claims is to be accorded the broadest interpretation so as to encompass all such modifications, equivalent structures and functions.

## Claims

1. An elastic surface wave apparatus comprising:
an input terminal (8);
an output terminal (9);
a three-electrode type longitudinally coupled SAW resonator filter (I) having a central IDT (1a) and a pair of outer IDTs (2a, 2b) disposed on both sides of the central IDT (1a), an electrode on one side of the central IDT (1a) being connected to the output terminal (9);
a series arm one-port resonator (4) including an IDT (4a) and having a resonance frequency within a pass band of the three-electrode type longitudinally coupled SAW resonator filter (1), an electrode on one side of the IDT (4a) being connected to the input terminal (8), and an electrode on the other side of the IDT (4a) being connected with the outer IDTs (2a, 2b); and
a parallel arm one-port resonator (6) including an IDT (6a) and having an anti-resonance frequency within a pass band of the three-electrode type longitudinally coupled SAW resonator filter (1), an electrode on one side of the IDT being connected to the output terminal (9), and an electrode on the other side of the IDT (6a) being grounded.

2. An elastic surface wave apparatus according to claim 1, wherein the three-electrode type longitudinally coupled SAW resonator filter (I) further has a pair of reflectors (3a, 3b) disposed on both sides of the outer IDTs (2a, 2b).

3. An elastic surface wave apparatus according to claim 1 or 2, wherein the series arm one-port resonator (4) further includes a pair of reflectors (5a, 5b) disposed on both sides of the IDT (4a).

4. An elastic surface wave apparatus according to any one of claims 1 to 3, wherein the parallel arm one-port resonator (6) further includes a pair of reflectors (7a, 7b) disposed on both sides of the IDT (6a).

5. An elastic surface wave apparatus according to any one of claims 1 to 4, further comprising a 36° Y-X LiTaO₃ substrate, and a three-electrode type longitudinally coupled SAW resonator filter (1) disposed thereon.

## Patentansprüche

1. Eine Elastische-Oberflächenwellen-Vorrichtung mit Folgenden Merkmalen:
einem Eingangsanschluß (8);
einem Ausgangsanschluß (9);
einem längsgekoppelten SAW-Resonatorfilter (1) eines Dreielektrodentyps, das einen mittleren Interdigitalwandler (IDT) (1a) und ein Paar von äußeren IDTs (2a, 2b) aufweist, die an beiden Seiten des mittleren IDT (1a) angeordnet sind, wobei eine Elektrode an einer Seite des mittleren IDT (1a) mit dem Ausgangsanschluß (9) verbunden ist;
einem Reihenarm-Eintor-Resonator (4), der einen IDT (4a) umfaßt und eine Resonanzfrequenz in einem Durchlaßband des längsgekoppelten SAW-Resonatorfilters (1) vom Dreielektrodentyp aufweist, wobei eine Elektrode an einer Seite des IDT (4a) mit dem Eingangsanschluß (8) verbunden ist und eine Elektrode an der anderen Seite des IDT (4a) mit den äußeren IDTs (2a, 2b) verbunden ist; und
einem Parallelarm-Eintor-Resonator (6), der einen IDT (6a) umfaßt und eine Antiresonanzfrequenz in einem Durchlaßband des längsgekoppelten SAW-Resonatorfilters (1) vom Dreielektrodentyp aufweist, wobei eine Elektrode an einer Seite des IDT mit dem Ausgangsanschluß (9) verbunden ist und eine Elektrode an der anderen Seite des IDT (6a) geerdet ist.

2. Eine Elastische-Oberflächenwellen-Vorrichtung gemäß Anspruch 1, bei der das längsgekoppelte SAW-Resonatorfilter (1) vom Dreielektrodentyp ferner ein Paar Reflektoren (3a, 3b) aufweist, die an beiden Seiten der äußeren IDTs (2a, 2b) angeordnet sind.

3. Eine Elastische-Oberflächenwellen-Vorrichtung gemäß Anspruch 1 oder 2, bei der der Reihenarm-Eintor-Resonator (4) ferner ein Paar Reflektoren (5a, 5b) umfaßt, die an beiden Seiten des IDT (4a) angeordnet sind.

4. Eine Elastische-Oberflächenwellen-Vorrichtung gemäß einem der Ansprüche 1 bis 3, bei der der Parallelarm-Eintor-Resonator (6) ferner ein Paar Reflektoren (7a, 7b) umfaßt, die an beiden Seiten des IDT (6a) angeordnet sind.

5. Eine Elastische-Oberflächenwellen-Vorrichtung gemäß einem der Ansprüche 1 bis 4, die ferner ein 36°-Y-X-LiTaO₃-Substrat und ein längsgekoppeltes SAW-Resonatorfilter (1) vom Dreielektrodentyp, das auf demselben angeordnet ist, aufweist.

## Revendications

1. Dispositif à onde de surface élastique comprenant :
une borne d'entrée (8),
une borne de sortie (9),
un filtre à résonateur SAW couplé longitudinalement du type à trois électrodes (1) comportant un transducteur IDT central (1a) et une paire de transducteurs IDT extérieurs (2a, 2b) disposés des deux côtés du transducteur IDT central (1a), une électrode d'un premier côté du transducteur IDT central (1a) étant reliée à la borne de sortie (9),
un résonateur de branche série à un point d'accès (4) comprenant un transducteur IDT (4a) et présentant une fréquence de résonance à l'intérieur d'une bande passante du filtre à résonateur SAW couplé longitudinalement du type à trois électrodes (1), une électrode d'un premier côté du transducteur IDT (4a) étant reliée à la borne d'entrée (8), et une électrode de l'autre côté du transducteur IDT (4a) étant reliée aux transducteurs IDT extérieurs (2a, 2b), et
un résonateur de branche parallèle à un point d'accès (6) comprenant un transducteur IDT (6a) et présentant une fréquence d'anti-résonance à l'intérieur d'une bande passante du filtre à résonateur SAW couplé longitudinalement du type à trois électrodes (1), une électrode d'un côté du transducteur IDT étant reliée à la borne de sortie (9), et une électrode de l'autre côté du transducteur IDT (6a) étant mise à la masse.

2. Dispositif à onde de surface élastique selon la revendication 1, dans lequel le filtre à résonateur SAW couplé longitudinalement du type à trois électrodes (1) comporte en outre une paire de réflecteurs (3a, 3b) disposés des deux côtés des transducteurs IDT extérieurs (2a, 2b).

3. Dispositif à onde de surface élastique selon la revendication 1 ou 2, dans lequel le résonateur de la branche série à un point d'accès (4) comprend en outre une paire de réflecteurs (5a, 5b) disposés des deux côtés du transducteur IDT (4a).

4. Dispositif à onde de surface élastique selon l'une quelconque des revendications 1 à 3, dans lequel le résonateur de la branche parallèle à un point d'accès (6) comprend en outre une paire de réflecteurs (7a, 7b) disposés des deux côtés du transducteur IDT (6a).

5. Dispositif à onde de surface élastique selon l'une quelconque des revendications 1 à 4, comprenant en outre un substrat de LiTaO₃ à Y-X à 36°, et un filtre à résonateur SAW couplé longitudinalement du type à trois électrodes (1) disposé sur celui-ci.
